# EUROPÄISCHE PATENTSCHRIFT

(11) **EP 0 555 519 B1**
(45) Veröffentlichungstag und Bekanntmachung des Hinweises auf die Patenterteilung: **22.01.1997**
(21) Anmeldenummer: 92113075.3
(22) Anmeldetag: 31.07.1992
(51) Int. Cl.: C23C 14/32, C23C 14/56, H01J 37/32

(54) **Vakuumbeschichtungsanlage**
Vacuum-coating apparatus
Appareillage de revêtement sous vide

(30) Priorität: 08.02.1992 DE 4203632
(43) Veröffentlichungstag der Anmeldung: 18.08.1993
(73) Patentinhaber: Balzers und Leybold Deutschland Holding Aktiengesellschaft, 63450 Hanau (DE); Toppan Printing Co., Ltd., Taito-ku Tokyo (JP)
(72) Erfinder: Grimm, Helmut, Dr., W-6100 Darmstadt 12 (DE); Krug, Thomas, Dr., W-6450 Hanau 1 (DE); Meier, Andreas, Dipl.-Phys., W-7417 Pfullingen (DE); Rübsam, Klemens, Dipl.-Phys., W-6485 Jossgrund (DE); Steiniger, Gerhard, Dipl.-Phys., W-6451 Ronneburg (DE); Gamo,Mika, Kasukaba-Shi Saitama (JP); Sekiguchi,Mamoru, Kawaguchi-Shi Saitama (JP); Kano,Mitsuru, Shinjuku-Ku Tokyo (JP); Yasujima,Hiroyuki, Koto-Ku Tokyo (JP); Miayamoto,Takashi, Kitakatushika-Gun Saitama (JP); Sasaki,Noboru, Kitakatushika-Gun Saitama (JP)
(74) Vertreter: Schickedanz, Willi, Dipl.-Ing.

(56) Entgegenhaltungen:
- EP-A- 0 263 880
- EP-A- 0 271 682
- WO-A-91/12353
- DE-A- 2 141 723
- US-A- 4 683 838
- US-A- 4 683 838
- Patent abstract of Japan 14(nr.225)(E-0927)(JP-2056897)

## Beschreibung

Die Erfindung betrifft eine Vakuumbeschichtungsanlage nach dem Oberbegriff des Patentanspruchs 1.

Transparente Kunststoffolien werden im verstärkten Maße für die Verpackung von Lebensmitteln eingesetzt In erster Linie kommen hierbei Folien aus Polymer-Kunststoffen in Frage, die zwar flexibel sind, aber den Nachteil aufweisen, für Aromastoffe, Wasser oder Sauerstoff durchlässig zu sein. Wenn eine Diffusion solcher Stoffe ausgeschlossen werden soll, werden deshalb im allgemeinen Aluminiumfolien oder Kunststoffolien mit aufgedampftem Aluminium verwendet. Diese haben jedoch den Nachteil, daß sie relativ schwer zu entsorgen und für Mikrowellen und Licht nicht durchlässig sind. Durch die Verbreitung von Mikrowellenherden in nahezu allen Haushalten der industrialisierten Länder ist jedoch die Mikrowellendurchlässigkeit des Verpackungsmaterials in vielen Fällen von entscheidender Bedeutung.

Um die Vorteile der Kunststoffolien, die für Mikrowellen durchlässig sind, mit den Vorteilen der Aluminiumfolien, die eine absolute Sperre für Aromastoffe, Wasser und Sauerstoff bilden, zu vereinigen, ist es bereits bekannt, Polymer-Folien mit Metalloxiden zu beschichten. Hierbei spielt Siliziumoxid als Beschichtungsmaterial eine besondere Rolle. Die mit Siliziumoxid beschichteten Kunststoffolien haben bezüglich der Laminatstruktur und dem Barriereverhalten gegenüber Sauerstoff, Wasserdampf und Aroma ähnliche Eigenschaften wie mit Aluminiumfolie oder mit Aluminium beschichtete Kunststoffolien.

Die Beschichtung von Kunststoffolien mit Metalloxiden wie SiOₓ erfordert jedoch eine Prozeßtechnik, die sich stark von den üblichen Beschichtungstechniken unterscheidet, weil Metalloxide im Gegensatz zu Metallen aus der festen Phase heraus verdampft werden müssen.

Die Herstellung von SiOₓ-Schichten erfolgt durch das Verdampfen von SiO mittels eines Verdampfungsofens oder mittels Elektronenstrahl-Verdampfung (vgl. T. Krug, K. Rübsam: Die neue "gläserne" Lebensmittelverpackung" in "neue verpackung", Hüthig-Verlag, 1991). Da SiO sublimiert - also direkt aus dem festen Zustand und nicht über eine flüssige Phase verdampft - ist ein spezieller Tiegel notwendig. Zur Erzielung von Folienbandgeschwindigkeiten von einigen m/s, die eine Voraussetzung für eine ökonomische Produktion zu akzeptablen Kosten darstellen, sind Tiegel für Verdampfertemperaturen von ca. 1.350 °C notwendig. Der SiO_{x = 1}-Dampf oxidiert in einer kontrollierten, reaktiven Atmosphäre, um auf einer zu beschichtenden Folie einen Oxidationsgrad von x = 1,5 bis 1,8 zu erreichen. SiOx-Schichten, die dünner als 200 nm (2.000 Å) sind, haben den Vorteil, daß sie leicht biegbar sind. Außerdem ist SiOₓ chemisch inert und korrosionsbeständig gegen Wasser.

SiO kann entweder mittels eines Verdampfungsofens oder mit Hilfe eines Elektronenstrahls verdampft werden, da es einen relativ hohen Dampfdruck hat. Um die erforderlichen höheren Abdampfraten auch bei anderen Metalloxiden, z. B. MgO, oder Mischungen von Metalloxiden, z. B. MgO + SiO₂, zu erreichen, sind allerdings Temperaturen von 1.800 °C oder mehr notwendig. Diese sind mit hohem Wirkungsgrad nur mit Elektronenstrahlverdampfern erzielbar. Die Haft-, Transparenz- und Barriereeigenschaften einer beschichteten Folie hängen im wesentlichen von der Geschwindigkeit ab, mit der die verdampften Metalloxide auf die Folie auftreffen.

Der Erfindung liegt die Aufgabe zugrunde, die Eigenschaften einer Metalloxid-Beschichtung auf einer Kunststoffolie zu verbessern.

Diese Aufgabe wird mit einer Vorrichtung gemäß den Merkmalen des Patentanspruchs 1 gelöst.

Der mit der Erfindung erzielte Vorteil besteht insbesondere darin, daß die verdampften Atome und Moleküle durch die Mikrowellen ionisiert oder wenigstens angeregt werden, so daß sie auf der Kunststoffolie eine Schicht mit verbesserten Eigenschaften bilden. Die Aufwachsrate der Schicht beträgt hierbei etwa 500-1000 nm/s (5.000 bis 10.000 Å/s). Der Dampfdruck des Verdampfungsmaterials zwischen dem Verdampfungstiegel und dem zu beschichtenden Substrat liegt bei ca. 10⁻² mbar bis 1 mbar und ist somit ausreichend, um das Zünden eines Plasmas aufgrund der Einwirkung von Mikrowellen zu bewirken. Ein Hilfsgas, wie es z. B. beim Sputtern oder bei der Plasma-CVD-Technik benötigt wird, kann entfallen. Allerdings können während der Beschichtung auch Gase, z. B. O₂, H₂O oder CO₂, in den Beschichtungsraum eingelassen werden, deren Reaktion mit dem verdampften Material durch das Plasma verstärkt oder erst ermöglicht wird.

Ein Ausführungsbeispiel der Erfindung ist in der Zeichnung dargestellt und wird im folgenden näher beschrieben. Es zeigen:
- Fig. 1: eine perspektivische Ansicht einer erfindungsgemäßen Hochraten-Bedampfungsanlage für Kunststoffolien;
- Fig. 2: eine teilweise geschnittene Seitenansicht der Hochraten-Bedampfungsanlage nach Fig. 1;
- Fig. 3: eine vergrößerte Darstellung eines Ausschnitts aus Fig. 2;
- Fig. 4: eine Draufsicht auf die Bedampfungsanlage gemäß Fig. 2;
- Fig. 5: eine Seitenansicht einer Elektronenstrahlkanone und einer Mikrowellen-Hornantenne;
- Fig. 6: eine Draufsicht auf die Mikrowellen-Hornantenne der Fig. 5.

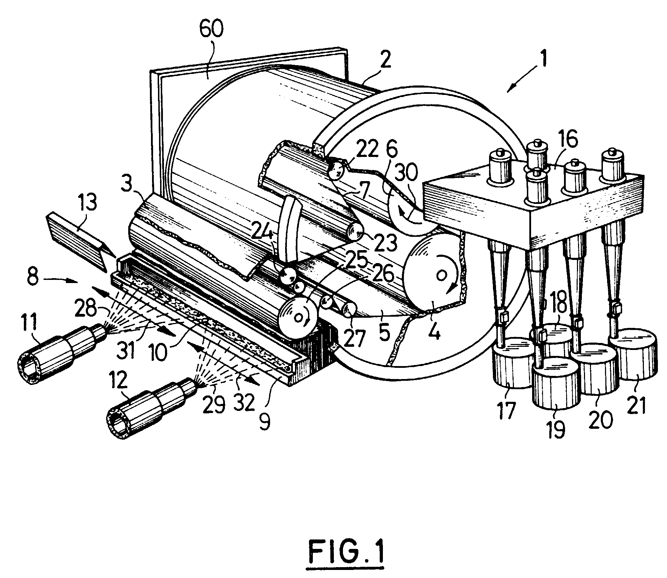

In der Fig. 1 ist eine perspektivische Ansicht einer erfindungsgemäßen Hochraten-Bedampfungsanlage 1 gezeigt. Diese Anlage weist zwei Kammern 2, 3 auf, von denen die eine Kammer 2 eine Abwickelrolle 4 für eine unbeschichtete Kunststoffolie 5 sowie eine Aufwickelrolle 6 für eine beschichtete Kunststoffolie 7 enthält, während die andere Kammer 3 mit der eigentlichen Bedampfungsanlage 8 ausgerüstet ist. Von der zweiten Kammer 3 ist nur ein kleiner Teil zu erkennen; der größere Teil ist weggelassen, um die Bedampfungsanlage 8 besser zu erkennen. Diese Bedampfungsanlage 8 besteht im wesentlichen aus einem Tiegel 9 mit zu verdampfendem Material 10, zwei Elektronenstrahlkanonen 11, 12 und einem Mikrowellensender, von dem nur Teile einer Hornantenne 13 zu erkennen sind.

An der ersten Kammer 2 ist ein Absaugstutzen 16 angeflanscht, der mehrere Vakuumpumpen 17 bis 21 trägt Mit diesen Vakuumpumpen wird die Kammer von 1 bar bis auf einen Druck von ca. 10⁻² mbar leergepumpt. Die Kammer 3 ist ebenfalls mit einer Vakuumpumpe versehen, die jedoch nicht dargestellt ist. Bei dieser Vakuumpumpe handelt es sich vorzugsweise um eine Diffusionspumpe, die ein Vakuum von 10⁻⁴ mbar erzeugt. Für die Evakuierung der Elektronenstrahlkanonen 11, 12 kann eine nicht dargestellte Turbomolekularpumpe vorgesehen sein. Die beiden Kammern 2, 3 sind durch kleine Schlitze miteinander verbunden, die notwendig sind, um die zu beschichtende Folie 5 über Umlenkwalzen 22 bis 27 von einer Kammer 2 bzw. 3 in die jeweils andere Kammer 3 bzw. 2 zu bringen. Die Druckdifferenz zwischen beiden Kammern 2, 3 beträgt demnach zwei Zehnerpotenzen.

Nicht dargestellt ist eine magnetische Ablenkeinheit, welche die waagrecht einfallenden Elektronenstrahlen 28, 29 der Elektronenstrahlkanone 11, 12 senkrecht auf das zu verdampfende Material 10 umlenkt. Mit 60 ist eine Platte bezeichnet, die Teil einer Vorrichtung ist, die mit wesentlichen Teilen der gesamten Anlage in Verbindung steht. Diese Teile können aus der Kammer 2 herausgefahren werden, so daß die Kammer leicht zu warten ist.

Die Beschichtung der Kunststoffolie 5 in der Anlage 1 wird im folgenden beschrieben.

Ein nicht dargestellter Antriebsmotor treibt die Aufwickelwalze 6 in Richtung des Pfeils 30 an, in welche das Ende der beschichteten Folie 7 eingehängt ist. Hierdurch wird die unbeschichtete Folie 5 von der Abwickelwalze 4 abgewickelt und über die Umlenkrollen 26, 27 auf die Beschichtungsrolle 25 gegeben. Dort wird die Folie 5 mit Materialteilchen bombardiert, die aufgrund der Erwärmung des Beschichtungsmaterials 10 durch die Elektronenstrahlen 28, 29 verdampfen und sich auf der Folie 5 niederschlagen. Die Elektronenstrahlen 28, 29 werden - was durch die Pfeile 31, 32 angedeutet ist - wenigstens in einer Richtung hin- und herbewegt, so daß das Material 10 über die ganze Länge des Tiegels 9 verdampft wird. Mit der symbolisch dargestellten Hornantenne 13 wird in den Raum zwischen der Walze 25 und dem Tiegel Mikrowellenenergie eingebracht, welche die im Tiegel 9 verdampfenden Materialteilchen ionisieren oder wenigstens anregen. Hierdurch entsteht zwischen Tiegel 9 und Walze 25 eine hell leuchtende Plasmawolke, die sofort verlischt, wenn die Mikrowelle abgeschaltet wird.

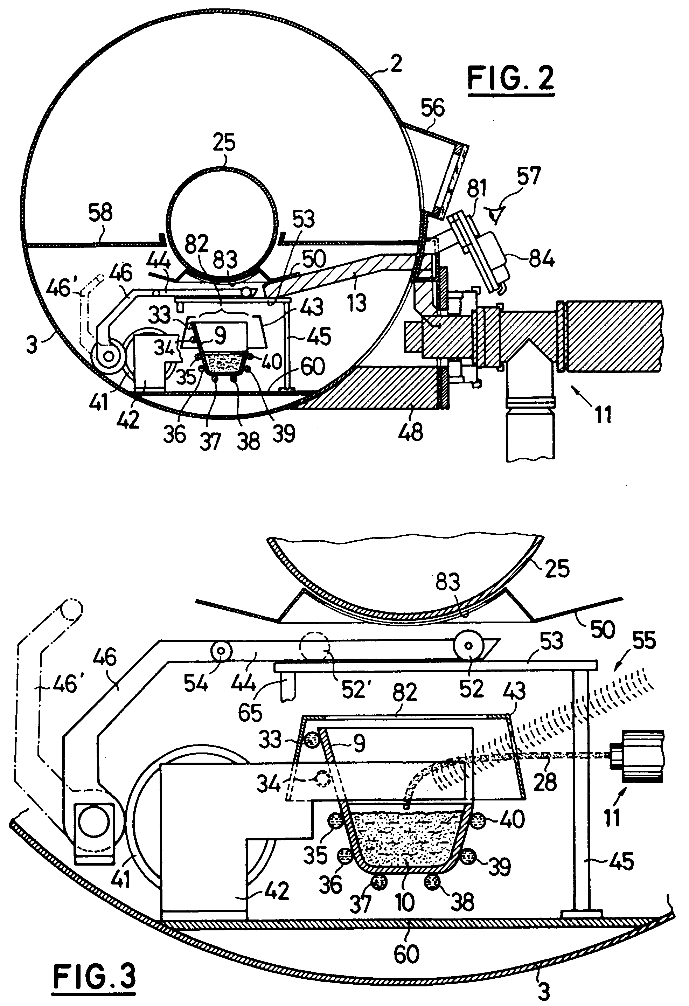

In der Fig. 2 ist ein Schnitt durch die beiden Kammern 2, 3 der Fig. 1 dargestellt, wobei allerdings die Kammern 2, 3 insoweit abgewandelt sind, als sie nun auf einem gemeinsamen Umfang liegen und durch eine sichtbare Trennwand 58 voneinander getrennt sind.

Die obere Kammer 2 weist ein Fenster 56 auf, durch das ein Beobachter in die Kammer 2 hineinsehen kann. Auch in die Kammer 3 kann über ein Fenster 81, unter dem sich ein Stroboskop 84 befindet, Einblick gewonnen werden, was durch das Auge 57 symbolisiert ist. Von den verschiedenen Walzen ist der besseren Übersichtlichkeit halber nur die Beschichtungswalze 25 dargestellt. Bei dem Tiegel 9 erkennt man, daß er von Kühlwasserrohren 33 bis 40 umgeben ist. Außerdem befindet sich neben dem Tiegel 9 eine große Magnetspule 41, die mit einem Jochblech 42 verbunden ist, von dem nur ein Teil dargestellt ist. Um den Tiegel 9 herum ist eine Tiegelabdeckung 43 vorgesehen, über der sich ein beweglicher Schieber 44 befindet, der auf einer Auflage 53 ruht, die sich über Stützen 45 auf einem Boden 60 abstützt. Die Tiegelabdeckung 43 weist in der Mitte eine Öffnung 82 auf, durch die verdampfte Teilchen vom Tiegel 9 zur Walze 25 gelangen können. Der Schieber 44 kann mittels eines Dreharms 46 unter die Walze 25 und von dieser wegbewegt werden. Er dient dazu, den Teilchenstrom vom Tiegel 9 zur Walze 25 zu unterbrechen oder freizugeben. Mit 11 ist die Elektronenstrahlkanone bezeichnet, die über einen Flansch 48 an die Kammer 3 angeflanscht ist. Oberhalb der Elektronenstrahlkanone 11 und in der Kammer 3 ist die Mikrowellen-Hornantenne 13 angeordnet, die Mikrowellen in den Raum zwischen Tiegel 9 und Walze 25 sendet.

Die Fig. 3 zeigt einen vergrößerten Ausschnitt aus Fig. 2. Man erkennt hierbei ein Abdeckblech 50 mit einer Öffnung 83 unterhalb der Walze 25, das zur seitlichen Begrenzung des Teilchenstroms dient; außerdem ist zu erkennen, daß der Schieber 44 auf Rollen 52 gelagert ist, die auf der Auflage 53 ruhen, die mit der Stütze 45 verbunden ist. Die zurückgezogene Position der Rolle 52 ist mit 52' bezeichnet. Eine zweite Stütze 65 ist abgebrochen dargestellt. Der Dreharm 46 ist über ein Gelenk 54 an den Schieber 44 gekoppelt. Das Jochblech 42 ist in der Fig. 3 vollständig dargestellt, so daß man erkennt, daß es sich über die ganze Breite des Tiegels 9 erstreckt.

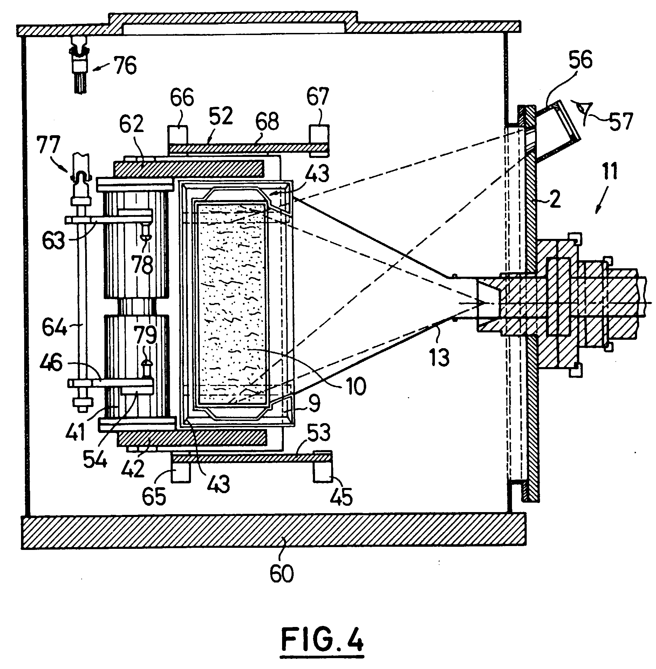

In der Fig. 4 ist die Anordnung der Fig. 2 in einer Ansicht von oben gezeigt, wobei einige Teile weggelassen und andere Teile hinzugefügt sind. Die Hornantenne 13 reicht mit ihrer Öffnung bis dicht über den Tiegel 9. Dem Jochblech 42 steht ein zweites Jochblech 62 gegenüber, so daß zwischen beiden Jochblechen 42,62 ein Magnetfeld verläuft, das den von der Elektronenkanone 11 kommenden Elektronenstrahl 28 auf die Oberfläche des im Tiegel 9 befindlichen Materials 10 umlenkt. Außer dem Arm 46 ist noch ein zweiter Arm 63 vorgesehen, der auf derselben Achswelle 64 angeordnet ist wie der Arm 46.

Man erkennt aus der Fig. 4 außerdem, daß der Stütze 45 eine zweite Stütze 65 zugeordnet ist, wobei beide Stützen 45, 65 über die Auflage 53 miteinander verbunden sind. Auf der gegenüberliegenden Seite des Tiegels 9 ist eine entsprechende Anordnung mit den Bezugszahlen 66,67,68 versehen. Die Rolle 52 (Fig.3) rollt auf der Auflage 53 ab. Entsprechendes gilt für eine zweite nicht dargestellte Rolle, die auf der Auflage 68 abrollt. Der in der Fig. 4 nicht erkennbare Schieber 44 wird von Zapfen 78, 79 gehalten, die in den Schieber 44 eingreifen. Mit 76, 77 sind Gelenkwellen bezeichnet, die von einem nicht dargestellten Motor angetrieben werden.

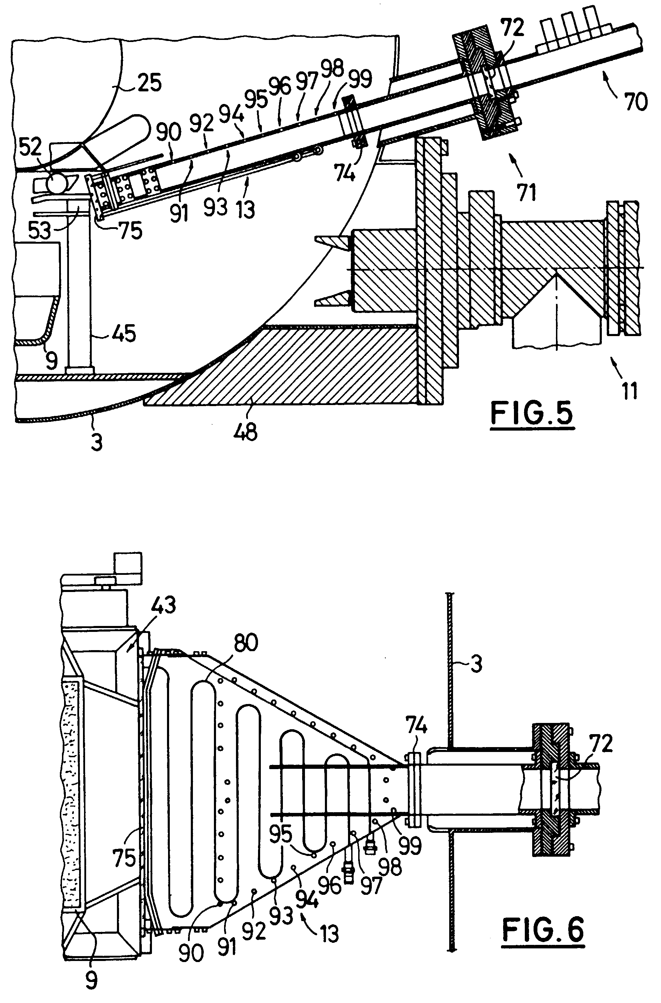

In der Fig. 5 ist die Hornantenne 13 am Gehäuse 3 noch einmal detailliert in einer Ausschnittvergrößerung der Fig. 2 dargestellt. Man erkennt hierbei, daß die Hornantenne 13 mit ihrem Ende 75 sehr nahe an den Tiegel 9 heranreicht. Die Hornantenne 13 ist mit einem Tuner 70 über ein Fenster 71 verbunden, das eine Schnittstelle zwischen Vakuum und Luft darstellt und eine Quarzscheibe 72 enthält, durch welche Mikrowellen treten können. Während der Verdampfung des Materials 10 herrscht vor einem zweiten Quarzfenster 75, d.h. in der Kammer 3, ein Dampfdruck des Verdampfungsmaterials von 10⁻² mbar oder mehr, so daß das Plasma allein aufgrund der eingestrahlten Miktowelle zündet. Zwischen den Fenstern 75 und 72, also in der Hornantenne 13 selbst, herrscht ein Druck von 10⁻⁴ mbar, so daß das Plasma nicht zünden kann. Damit sich der Druck von 10⁻⁴ mbar einstellt, sind auf der Oberseite der Hornantenne 13 Löcher 90 bis 99 vorgesehen. Die Unterseite der Hornantenne 13 weist dagegen keine Löcher auf. Der Raum zwischen den Fenstern 75 und 72 ist somit mit dem Hintergrundvakuum der Anlage verbunden.

Eine Draufsicht auf die im wesentlichen isoliert dargestellte Hornantenne 13 zeigt die Fig. 6. Man erkennt hierbei eine aufgelötete schlangenförmige Kühlleitung 80 sowie die Löcher 90 bis 99.

Der Elektronenstrahl 28 der Elektronenstrahlkanone 11 wird durch eine Steueranordnung, die sich in der Elektronenstrahlkanone 11 selbst befindet, über die Oberfläche des Tiegelinhalts 10, d.h. des zu verdampfenden Materials 10 bewegt bzw. gescannt. Das verdampfte Material wird hierauf durch die Mikrowelle 55 angeregt, deren Strahlungsleistung nahezu vollständig von den Teilchen des verdampften Materials absorbiert wird, so daß das Plasma zündet. Anders als bei bereits bekannten Anordnungen, bei denen eine Hornantenne zum Einbringen von Mikrowellenenergie in ein Plasma verwendet wird (vgl. z. B. US-PSen 4 611 121,4 987 346), findet jedoch keine Elektronenzyklotronresonanz (ECR) statt, sondern die Teilchen werden nur mehr oder weniger angeregt bzw. ionisiert. Hierbei wird das Plasma nur aus dem Dampf des Verdampfungsmaterials gebildet, und es muß nicht notwendigerweise ein zusätzliches Gas zugeführt werden, wie z. B. Argon oder Sauerstoff beim Sputtern bzw. Organosilane, die bei der Plasma-CVD-Technik notwendig sind. Ein ECR-Betrieb wäre mit der Anordnung gemäß der Fig. 1 bis 6 nicht möglich, weil hierzu ein Magnetfeld von einer Stärke erforderlich wäre, welche die Stärke des von der Spule 41 erzeugten Magnetfelds übersteigt. Beim ECR-Betrieb werden die Elektronen durch ein Magnetfeld auf eine Kreisbahn gezwungen, während im vorliegenden Fall das Magnetfeld lediglich die Aufgabe hat, die Elektronen des Elektronenstrahls um etwa 90 Grad nach unten abzulenken.

Die Anregung, welche die Teilchen durch die Mikrowelle erfahren, genügt indessen auch ohne einen ECR-Effekt, die Ionisations- und Anregungsrate der verdampften Teilchen zu erhöhen und die aufgedampften Schichten zu verbessern. Wie die Erfahrung zeigt, bildet sich auf der zu beschichtenden Folie eine negative Polarität aus, welche positive Ionen aus dem durch die Mikrowelle erzeugten Plasma auf die Folie beschleunigt, so daß sie dort besser haften. Die negative Aufladung der Folie ist im wesentlichen durch die streuenden Elektronen des Elektronenstrahls 28 bedingt, die von der Oberfläche des zu schmelzenden Materials 10 direkt zur Folie gelangen.

Ein ECR-Betrieb zwischen der Oberfläche des zu schmelzenden Materials und der Folie wäre auch nicht mit einem zusätzlichen Magnetfeld möglich, das beispielsweise in der Nähe der Folie und damit oberhalb des von der Spule 41 erzeugten Magnetfelds angeordnet wäre, weil dieses Magnetfeld die Bahnen der Elektronen des Elektronenstrahls 28 beeinflussen würde. Eine Abschirmung zwischen den beiden Magnetfeldern ließe sich ebenfalls nicht realisieren, weil es - mit Ausnahme von Supraleitern - keinen Werkstoff mit verschwindender Permeabilität gibt. Demzufolge existiert kein Werkstoff, der bei normaler Temperatur als ein magnetischer Isolator angesehen werden kann. Der noch verbleibende Weg der Magnetfeldkompensation wäre zu aufwendig.

Die verwendete Mikrowelle 55 hat vorzugsweise die übliche Industriefrequenz von 2,45 GHz. Der von der Elektronenstrahlkanone 11 ausgesandte Elektronenstrahl weist eine Stromstärke von 1 bis 5 A auf. Damit dieser Strahl um ca. 90 Grad abgelenkt werden kann, muß das von der Spule 41 erzeugte Magnetfeld eine Stärke von 5 · 10³ A/m aufweisen. Es versteht sich, daß anstelle von nahezu horizontal verlaufenden Elektronenstrahlen, die durch ein Magnetfeld in den Tiegel abgelenkt werden müssen, auch schräg verlaufende Elektronenstrahlen vorgesehen werden können, die direkt auf das zu verdampfende Material treffen. In diesem Fall kann auf ein ablenkendes Magnetfeld verzichtet werden.

In den Fig. 3 bis 5 ist die Hornantenne, mit der die Mikrowellen eingestrahlt werden, auf derselben Seite wie die Elektronenstrahlkanone angeordnet. Es versteht sich jedoch, daß Hornantenne und Elektronenstrahlkanone auch an gegenüberliegenden Seiten des Tiegels angeordnet sein können. Beispielsweise kann die Elektronenstrahlkanone, bezogen auf die Darstellung der Fig. 3, von links oben nach rechts unten gerichtet sein, so daß die Elektronenstrahlen nicht durch einen Magneten abgelenkt werden müssen, sondern direkt auf die Oberfläche des Schmelzguts auftreffen. In diesem Fall könnte die Mikrowelle von der rechten Seite aus eingestrahlt werden, und zwar von jeder beliebigen Richtung aus.

## Patentansprüche

1. Vakuumbeschichtungsanlage, mit
a) einem Behälter (9), in dem sich zu verdampfendes Material (10) befindet;
b) einer Verdampfervorrichtung (11) zum Verdampfen des in dem Behälter (9) befindlichen Materials (10);
c) einer Vorrichtung für die Aufnahme eines zu beschichtenden Materials (5), das sich in einem Abstand von dem zu verdampfenden Material (10) befindet;
d) einen Mikrowellensender (13, 70), der geeignet ist, Mikrowellen in den Raum zwischen dem zu verdampfenden Material (10) und dem zu beschichtenden Material (5) zu senden,
**dadurch gekennzeichnet**, daß
e) die Vorrichtung für die Aufnahme des zu beschichtenden Materials (5) eine Vorrichtung (25) für die Aufnahme einer Folie mit vorgegebener Breite ist,
f) die Breite des Behälters (9) wenigstens so groß ist wie die Breite der Folie, und
g) der Mikrowellensender (13, 70) eine Hornantenne mit einer Öffnung ist, deren Breite im wesentlichen der Breite des Behälters (9) entspricht.

2. Vakuumbeschichtungsanlage nach Anspruch 1, **gekennzeichnet durch** eine Transportvorrichtung (4, 6, 22 bis 27) für das zu beschichtende Material (5).

3. Vakuumbeschichtungsanlage nach Anspruch 1, **dadurch gekennzeichnet**, daß es sich bei dem zu beschichtenden Material um eine Kunststoffolie (7) handelt.

4. Vakuumbeschichtungsanlage nach den Ansprüchen 2 und 3, **dadurch gekennzeichnet**, daß die Transportvorrichtung eine Abwickelwalze (4), eine Aufwickelwalze (6) und eine Beschichtungswalze (25) aufweist, wobei derjenige Bereich der Kunststoffolie (7), der dem zu verdampfenden Material (10) zugewandt ist, beschichtet wird.

5. Vakuumbeschichtungsanlage nach einem oder mehreren der vorangegangenen Ansprüche, **dadurch gekennzeichnet**, daß zwei Vakuumkammern (2, 3) vorgesehen sind, von denen die eine Vakuumkammer (3) ein wesentlich besseres Vakuum aufweist als die andere Kammer (2) und daß in die eine Kammer (2) mit dem schlechteren Vakuum die Abwickelwalze (4), die Aufwickelwalze (6) und die Beschichtungswalze (25) angeordnet sind, während in der Kammer (3) mit dem besseren Vakuum der Behälter (9) mit dem zu verdampfenden Material vorgesehen ist.

6. Vakuumbeschichtungsanlage nach Anspruch 5, **dadurch gekennzeichnet**, daß zwischen den beiden Kammern (2, 3) eine Öffnung vorgesehen ist, durch welche die zu beschichtende Kunststoffolie von der einen Kammer (2) zur anderen Kammer (3) und umgekehrt gelangen kann.

7. Vakuumbeschichtungsanlage nach Anspruch 1, **dadurch gekennzeichnet**, daß die Verdampfervorrichtung eine Elektronenstrahlkanone (11) ist, die einen Elektronenstrahl (28) parallel und in einem Abstand von der Oberfläche des zu verdampfenden Materials (10) abgibt und daß ein Magnetfeld vorgesehen ist, welches den Elektronenstrahl (28) auf die Oberfläche des Materials (10) ablenkt.

8. Vakuumbeschichtungsanlage nach Anspruch 1, **dadurch gekennzeichnet**, daß die Verdampfervorrichtung eine Elektronenstrahlkanone ist, die einen Elektronenstrahl direkt auf das zu verdampfende Material abgibt.

9. Vakuumbeschichtungsanlage nach Anspruch 8, **dadurch gekennzeichnet**, daß die Hornantenne (13) ein mikrowellendurchlässiges Fenster (75) an ihrem Ausstrahlungsende und ein mikrowellendurchlässiges Fenster (72) an der Verbindungsstelle zu einem Mikrowellensender aufweist.

10. Vakuumbeschichtungsanlage nach Anspruch 8, **dadurch gekennzeichnet**, daß die Hornantenne (13) an ihrer Oberseite mit Löchern (90 bis 99) versehen ist, die eine Verbindung zu einer Vakuumkammer herstellen.

11. Vakuumbeschichtungsanlage nach Anspruch 9, **dadurch gekennzeichnet**, daß im Betrieb im Raum vor dem Fenster (75) des Ausstrahlungsendes ein Druck von 10⁻² mbar herrscht, während zwischen den beiden Fenstern (75, 72) ein Druck von 10⁻⁴ mbar herrscht.

12. Vakuumbeschichtungsanlage nach Anspruch 7, **dadurch gekennzeichnet**, daß die Hornantenne (13) oberhalb der Elektronenstrahlkanone (11) angeordnet ist und mit ihrer Längsachse zum Behälter (9) hin geneigt ist.

13. Vakuumbeschichtungsanlage nach Anspruch 7, **dadurch gekennzeichnet**, daß der Behälter (9) einen U-förmigen Querschnitt mit einer Ausbrechung für den Eintritt des Elektronenstrahls (28) aufweist.

14. Vakuumbeschichtungsanlage nach Anspruch 7, **dadurch gekennzeichnet**, daß das Magnetfeld mittels einer stromdurchflossenen Spule (41) erzeugt wird, die auf einem Joch mit zwei Seitenarmen angeordnet ist, wobei diese Seitenarme den Behälter (9) derart umgreifen, daß das zwischen ihm verlaufende Magnetfeld senkrecht auf der Längsrichtung des Elektronenstrahls (28) steht

15. Vakuumbeschichtungsanlage nach Anspruch 1, **dadurch gekennzeichnet**, daß eine bewegliche Blende (35, 44, 46, 52) zwischen dem Behälter (9) und der Beschichtungswalze (25) vorgesehen ist.

16. Vakuumbeschichtungsanlage nach Anspruch 1, **dadurch gekennzeichnet**, daß das Material (10) in dem Behälter ein Metalloxid ist.

17. Vakuumbeschichtungsanlage nach Anspruch 16, **dadurch gekennzeichnet**, daß das Material MgO oder SiO ist.

18. Vakuumbeschichtungsanlage nach Anspruch 1, **dadurch gekennzeichnet**, daß der Mikrowellensender eine Hornantenne (13) aufweist, die gegenüber einer Elektronenstrahlkanone (11) angeordnet ist.

## Claims

1. Vacuum-coating apparatus, comprising
a) a receptacle (9) which contains material (10) to be evaporated;
b) an evaporator device (11) for evaporating the material (10) contained in the receptacle (9);
c) a device for receiving a material (5) to be coated, which material is situated at a distance from the material (10) to be evaporated;
d) a microwave transmitter (13, 70), which is capable of transmitting microwaves into the space between the material (10) to be evaporated and the material (5) to be coated,
characterised in that
e) the device for receiving the material (5) to be coated is a device (25) for receiving a foil of predetermined width,
f) the width of the receptacle (9) is at least as large as the width of the foil, and
g) the microwave transmitter (13, 70) is a horn antenna with an opening whose width corresponds substantially to the width of the receptacle (9).

2. Vacuum-coating apparatus according to Claim 1, characterised by a transport arrangement (4, 6, 22 to 27) for the material (5) to be coated.

3. Vacuum-coating apparatus according to Claim 1, characterised in that the material to be coated is a plastic foil (7).

4. Vacuum-coating apparatus according to Claims 2 and 3, characterised in that the transport arrangement comprises a take-off roll (4), a take-up roll (6) and a coating roll (25), that region of the plastic foil (7) which faces the material (10) to be evaporated being coated.

5. Vacuum-coating apparatus according to one or more of the preceding claims, characterised in that two vacuum chambers (2, 3) are provided, of which the one chamber (3) has a substantially better vacuum than the other chamber (2) and in that the take-off roll (4), the take-up roll (6) and the coating roll (25) are arranged in the one chamber (2) with the poorer vacuum, while the receptacle (9) containing the material to be evaporated is provided in the chamber (3) with the better vacuum.

6. Vacuum-coating apparatus according to Claim 5, characterised in that between the two chambers (2, 3) there is provided an opening, through which the plastic foil to be coated is able to pass from the one chamber (2) to the other chamber (3) and vice versa.

7. Vacuum-coating apparatus according to Claim 1, characterised in that the evaporator device is an electron-beam gun (11) which emits an electron beam (28) parallel to and at a distance from the surface of the material (10) to be evaporated and in that there is provided a magnetic field which deflects the electron beam (28) onto the surface of the material (10).

8. Vacuum-coating apparatus according to Claim 1, characterised in that the evaporator device is an electron-beam gun which emits an electron beam directly onto the material to be evaporated.

9. Vacuum-coating apparatus according to Claim 8, characterised in that the horn antenna (13) has at its emitting end a window (75) which allows microwaves to pass through and at the junction to a microwave transmitter a window (72) which allows microwaves to pass through.

10. Vacuum-coating apparatus according to Claim 8, characterised in that the horn antenna (13) is provided at its upper side with holes (90 to 99) which establish a connection to a vacuum chamber.

11. Vacuum-coating apparatus according to Claim 9, characterised in that in the space in front of the window (75) of the emitting end a pressure of 10⁻² mbar prevails, while between the two windows (75, 72) a pressure of 10⁻⁴ mbar prevails.

12. Vacuum-coating apparatus according to Claim 7, characterised in that the horn antenna (13) is arranged above the electron-beam gun (11) and is inclined towards the receptacle (9) with its longitudinal axis.

13. Vacuum-coating apparatus according to Claim 7, characterised in that the receptacle (9) has a U-shaped cross-section with a broken-off portion for admitting the electron beam (28).

14. Vacuum-coating apparatus according to Claim 7, characterised in that the magnetic field is generated by means of a current-carrying coil (41) which is arranged on a yoke with two side arms, these side arms embracing the receptacle (9) in such a way that the magnetic field running between the latter is perpendicular to the longitudinal direction of the electron beam (28).

15. Vacuum-coating apparatus according to Claim 1, characterised in that a movable cover (35, 44, 46, 52) is provided between the receptacle (9) and the coating roll (25).

16. Vacuum-coating apparatus according to Claim 1, characterised in that the material (10) in the receptacle is a metal oxide.

17. Vacuum-coating apparatus according to Claim 16, characterised in that the material is MgO or SiO.

18. Vacuum-coating apparatus according to Claim 1, characterised in that the microwave transmitter has a horn antenna (13) which is arranged opposite an electron-beam gun (11).

## Revendications

1. Installation de dépôt sous vide, comprenant
a) un récipient (9) dans lequel se trouve la matière à évaporer (10);
b) un dispositif d'évaporation (11) pour l'évaporation de la matière (10) se trouvant dans le récipient (9);
c) un dispositif pour la réception d'une matière (5) à revêtir d'une couche, qui se trouve à distance de la matière à évaporer (10);
d) un émetteur de micro-ondes (13, 70) qui est approprié pour envoyer des micro-ondes dans l'espace entre la matière à évaporer (10) et la matière (5) à revêtir d'une couche,
caractérisée en ce que
e) le dispositif pour le logement de la matière (5) à revêtir d'une couche est un dispositif (25) pour le logement d'une feuille de largeur prédéterminée,
f) la largeur du récipient (9) étant au moins de même dimension que la largeur de la feuille et
g) l'émetteur de micro-ondes (13, 70) est une antenne à cornet avec une ouverture dont la largeur correspond sensiblement à la largeur du récipient (9).

2. Installation de dépôt sous vide selon la revendication 1, caractérisée par un dispositif de transport (4, 6, 22 à 27) pour une matière (5) à revêtir d'une couche.

3. Installation de dépôt sous vide selon la revendication 1, caractérisée en ce que pour la matière à revêtir d'une couche, il s'agit d'une feuille de matière élastique (7).

4. Installation de dépôt sous vide selon les revendications 2 et 3, caractérisée en ce que le dispositif de transport présente un cylindre dérouleur (4), un cylindre enrouleur (6) et un cylindre de dépôt de couche (25), la zone de la feuille de matière élastique (7) , qui est tournée vers la matière à évaporer (10), faisant l'objet d'un dépôt de couche.

5. Installation de dépôt sous vide selon l'un des revendications précédentes, caractérisée en ce qu'il est prévu deux enceintes à vide (2, 3) dont l'enceinte sous vide (3) présente un vide sensiblement meilleur que l'autre enceinte (2) et en ce que le cylindre dérouleur (4), le cylindre enrouleur (6) et le cylindre de dépôt de couche (25) sont disposés dans l'enceinte (2), qui a le plus mauvais vide, tandis que le récipient (9) avec la matière à évaporer est prévu dans l'enceinte (3) présentant le meilleur vide.

6. Installation de dépôt sous vide selon la revendication 5, caractérisée en ce qu'entre les deux enceintes (2, 3), il est prévu une ouverture par laquelle la feuille de matière plastique, à revêtir d'une couche, peut passer de l'enceinte (2) à l'autre enceinte (3) et inversement.

7. Installation de dépôt sous vide selon la revendication 1, caractérisée en ce que le dispositif d'évaporation est un canon à électrons (11) qui délivre un faisceau d'électrons (28) parallèlement et à distance de la surface de la matière à évaporer (10) et en ce qu'il est prévu un champ magnétique qui dévie le faisceau d'électrons (28) en direction de la surface de la matière (10).

8. Installation de dépôt sous vide selon la revendication 1, caractérisée en ce que le dispositif d'évaporation est un canon à électrons qui délivre un faisceau d'électrons directement sur la matière à évaporer.

9. Installation de dépôt sous vide selon la revendication 8, caractérisée en ce que l'antenne à cornet (13) présente une fenêtre (75), laissant passer les micro-ondes, sur son extrémité rayonnante, et une fenêtre (72), laissant passer les micro-ondes, à son point de jonction avec l'émetteur de micro-ondes.

10. Installation de dépôt sous vide selon la revendication 8, caractérisée en ce que l'antenne à cornet (13) présente, sur sa face supérieure, des trous (90 à 99) qui établissent une liaison avec une enceinte à vide.

11. Installation de dépôt sous vide selon la revendication 9, caractérisée en ce qu'en fonctionnement, dans l'espace devant la fenêtre (75) de l'extrémité rayonnante, il règne une pression de 10⁻² mbar, tandis qu'entre les deux fenêtres (75, 72), il règne une pression de 10⁻⁴ mbar.

12. Installation de dépôt sous vide selon la revendication 7, caractérisée en ce que l'antenne à cornet (13) est disposée en amont du canon à électrons (11) et son axe longitudinal est incliné en direction du récipient (9).

13. Installation de dépôt sous vide selon la revendication 7, caractérisée en ce que le récipient (9) présente une section transversale en forme de U avec une encoche pour l'entrée du faisceau d'électrons (28).

14. Installation de dépôt sous vide selon la revendication 7, caractérisée en ce que le champ magnétique est généré au moyen d'une bobine (41) qui est traversée par le courant et qui est disposée sur une culasse à deux bras latéraux, ces bras latéraux entourant le récipient (9) de telle sorte que le champ magnétique, passant entre ces dernières, est perpendiculaire au sens longitudinal du faisceau d'électrons (28).

15. Installation de dépôt sous vide selon la revendication 1, caractérisée en ce qu'il est prévu un écran mobile (35, 44, 46, 52) entre le récipient (9) et le cylindre de revêtement de couche (25).

16. Installation de dépôt sous vide selon la revendication 1, caractérisée en ce que la matière (10), se trouvant dans le récipient, est un oxyde de métal.

17. Installation de dépôt sous vide selon la revendication 16, caractérisée en ce que la matière est du MgO ou SiO.

18. Installation de dépôt sous vide selon la revendication 1, caractérisée en ce que l'émetteur de micro-ondes présente une antenne à cornets (13) qui est disposée en face du canon à électrons (11).
